# EUROPEAN PATENT SPECIFICATION

(11) **EP 0 455 658 B1**
(45) Date of publication and mention of the grant of the patent: **22.12.1993**
(21) Application number: 90901806.1
(22) Date of filing: 24.01.1990
(51) Int. Cl.: H05K 7/14

(54) **METHOD AND DEVICE FOR FASTENING AN ELECTRONIC CIRCUIT SUBSTRATE ONTO A SUPPORT**
VERFAHREN UND VORRICHTUNG ZUR FIXIERUNG EINES ELEKTRONISCHEN SCHALTUNGSSUBSTRATES AUF EINEM TRÄGER
PROCEDE ET DISPOSITIF DE FIXATION D'UN SUBSTRAT DE CIRCUIT ELECTRONIQUE SUR UN SUPPORT

(30) Priority: 25.01.1989 FR 8900891
(43) Date of publication of application: 13.11.1991
(73) Proprietor: SIEMENS AKTIENGESELLSCHAFT, 80333 München (DE)
(72) Inventor: COQUES, Pierre, F-31036 Toulouse Cédex (FR); DENEAU, Pascal, F-31036 Toulouse Cédex (FR)
(86) International application number: PCT/EP90/00133
(87) International publication number: WO 90/09090

(56) References cited:
- DE-U- 8 601 294
- FR-A- 1 445 156
- IBM TECHNICAL DISCLOSURE BULLETIN, vol. 19, no. 8, January 1977, New York US, page 3018, T.ROSS: "Self-pressurized contener with pressure indicator"
- IBM TECHNICAL DISCLOSURE BULLETIN, vol. 16, no. 10, March 1974, New York, US, page 3289; H.G. Bauer: "Vacuum Holding and testing fixture"

## Description

The present invention relates to a method and a device for fastening a plane electronic circuit substrate onto a plane support parallel to the latter using an adhesive product in the viscous state on one of the faces of the substrate or of the support to be fastened one on the other.

Electronic apparatuses currently have circuits which consist of active and/or passive components distributed over an insulating substrate on which conducting tracks are formed which connect the various components according to a predetermined connection plan. Circuits of this type must be protected from environmental attacks and, to this end, they are often enclosed in casings which form a mechanical protection for them. These substrates take the form of a rigid or semi-rigid board fitted with components, this board often being fastened simply by gluing to an internal face of a wall of the casing. In order to the this, a film of glue is traditionally deposited, by silk screen printing or application with a doctor blade, onto a face of the board and this coated face is placed by hand onto the face of the inner wall of the casing on which it is to be fastened. A degree of spreading of the glue between the two opposite glued surfaces is caused by sliding these two surfaces relative to each other. According to another technique, one or more drops of glue is deposited in the centre of the pieces to be assembled and their assembly is carried out simply by pressing these pieces against each other.

An apparatus for applying a layer of glue on a plane support onto which a semiconductor device has to be fastened is known from document DE-U 86 01 294. The glue is spread over the surface of the support with a scraper, but there is no available means for avoiding the presence of air bubbles in the layer of glue. Lastly, the assembly by pressing the substrate onto the surface of the casing implies the application, for example by the fingers of an operator, of sometimes very concentrated forces on the face of the substrate carrying the components, which may damage the said components or even the circuit formed on the substrate.

It has been possible to observe that the consequences of these disadvantages are (1) the formation of hot points during heat transfer between the substrate and a dissipator such as a heat sink or a ribbed casing, (2) parasitic vibrations during assembly by the ultra-sonic method, in particular when connecting wires etc, and (3) the substrate becoming unstuck when the environmental conditions are unfavourable and entail, for example, the application to the substrate of heat cycles, as is the case in particular in automobile electronics.

The object of the present invention is therefore to provide a method for fastening a substrate onto a support which does not have these disadvantages and which, in particular, enables the substrate to be fastened onto the support by an adhesive layer free from air bubbles, with a regular thickness and which is reproducible.

The object of the present invention is also to provide a method of this type enabling the application of concentrated forces to be avoided on the face of the substrate which carries a circuit and electronic components.

Further objects of the present invention are to provide a method of this type which lends itself to advanced automatization and to produce a device for the implementation of this method.

These objects of the invention are achieved, as well as others which will emerge in the course of the present description, with a method for fastening a plane electronic circuit substrate onto a plane support parallel to the latter, characterized in that (a) a looped line of an adhesive product in the viscous state is deposited on one of the faces of the substrate or of the support to be fastened one on the other, (b) these faces are placed opposite each other in order to establish a space defined by the line of adhesive and the areas of the opposing faces which are inside the line, (c) a reduced pressure is applied to this space so as to squash the line of adhesive between the two faces to be assembled, in order to spread the viscous adhesive in a layer with a substantially constant thickness and (d) the layer formed in this way is dried.

The present invention also enables a device to be produced for implementing this method, comprising means for receiving a unit consisting of a plane support and a substrate separated by a looped line of a viscous adhesive product, the plane support or the substrate being pierced with at least one opening which passes through its thickness to open out in the space defined by the line of adhesive and the opposing areas of the support and of the substrate which are inside the line of adhesive, this device being characterized in that it comprises suction means which can be connected to this opening for applying a reduced pressure to the said space relative to the environment so as to cause the viscous adhesive product to spread out in a uniform layer by squashing the line of adhesive between the substrate and the support.

In the attached drawing, given merely by way of example:
Figure 1 is a diagrammatic sectional view of a device for implementing the method according to the invention and
Figure 2 is a diagrammatic plan view of the device in Figure 1.

Reference is made to the figures which illustrate an essential intermediate phase of the fastening method according to the invention. The object of this method is to fasten a substrate 1 onto a support 2 by means of a uniformly distributed intermediate adhesive layer. By way of non-limiting example, the substrate may be that of a thick-layered hybrid circuit, in which case it is formed from alumina, glass, beryllium oxide, enamelled metal sheeting, anodized aluminium, etc. A network of conductors and resistors forming part of an electronic circuit is deposited on a substrate of this type by silk screen printing. The circuit is completed by active and passive components attached to the substrate. A hybrid circuit of this type is available either bare or coated in a resin, or alternatively packaged in a ceramic, metal or plastic casing. In the latter case, it may be fastened onto an internal wall of the casing by gluing, this wall of the casing then forming the support 2 which receives the substrate 1.

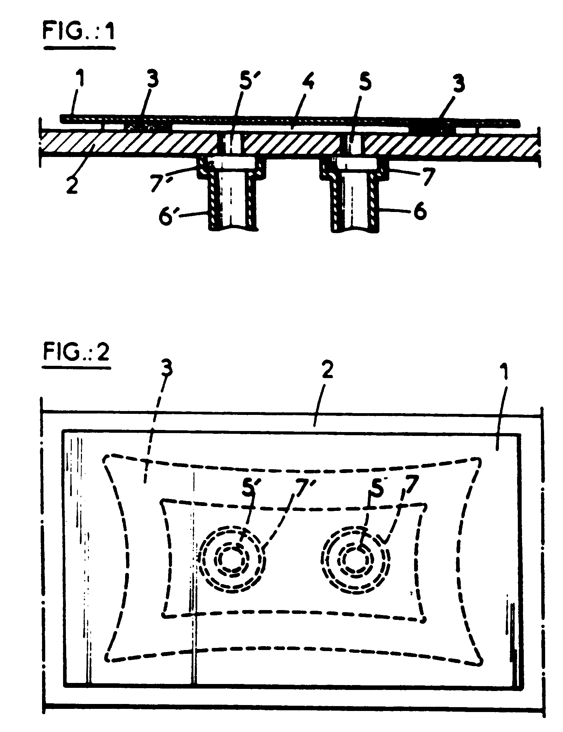

According to the invention, in order to fasten this substrate onto a support of this type, a looped line 3 of an adhesive product in the viscous state is deposited either on a face of the substrate or on the face of the support which is intended to face this substrate, these faces are placed one on the other, as shown in Figure 1, in order to establish a space 4 defined by the line 3 and the areas of the opposing faces which are inside the line 3, and reduced pressure is applied to the space 4 so as to squash the line 3 between the two faces to be assembled in order to spread the adhesive between these faces. Lastly, the layer formed in this way is dried.

In order to apply reduced pressure to the space 4 relative to the ambient atmospheric pressure, the invention proposes to pierce in the support 2 or in the substrate 1 at least one opening which connects the space 4 with the other face of the support 2 or of the substrate 1, this space being connected, in the region of this opening, to suction means forming a part of the device for implementing the method according to the invention. According to a first embodiment of the invention, the opening 5 is pierced in the support 2. According to a second embodiment (not shown) the opening is pierced in the substrate.

The suction means essentially comprise, in addition to a vacuum source (not shown), at least one duct 6 having attachment means such as a suction cap 7. Two ducts 6, 6' combined with suction caps 7, 7' respectively are shown in the drawing, designed so as to be attached to openings 5, 5' respectively, pierced in the support 2 (or to corresponding openings pierced in the substrate 1) so as to ensure a uniform distribution of the reduced pressure applied in the space 4 inside the line 3.

According to an advantageous embodiment of the device according to the invention, the suction caps 7, 7' form both means for receiving the support 2 in the gluing position and means for attaching the openings 5, 5' to the suction means.

The device according to the present invention may also advantageously comprise means for locating the openings 5, 5' and the suction caps 7, 7' during installation of the support 2 in the device with a view to the gluing operations.

The line of adhesive 3 necessary for the assembly may be formed either on the substrate 1 or on the support 2. By way of non-limiting example, an adhesive product appropriate for this use may be, for example, the glue DOW CORNING Q 19233. Whether this line of adhesive is formed on the substrate or on the support, it has been observed, when the substrate to be glued is rectangular in shape, that a more uniform spreading of this adhesive is obtained when the line 3 is given the shape shown in Figure 2, where this line follows an approximately cushion-shaped contour having the same axes of symmetry as the substrate 1 to be fastened on the support 2. The line of adhesive 3 may be deposited on the substrate or the support by any known coating method, for example by silk screen printing.

Whilst this adhesive is still fluid, the substrate 1 is superposed in location on the support 2, in the position shown in Figure 1. The start-up of the vacuum source then applies a reduced pressure to the space 4 and the ambient atmospheric pressure then applies a uniform pressure over the area of the substrate 1 which is inside the line 3, which causes the line of adhesive 3 to be squashed between the substrate and the support, thus causing a spreading of this adhesive in a layer with a thickness which is also uniform, between the support and the substrate. Advantageously, the adhesive spreads between the substrate and the support until it comes to plug the openings 5 and 5', which automatically simultaneously causes the application of a pressure on the substrate 1 to be ceased, the adhesive then being spread in a layer with a uniform thickness over the entire surface of the opposing areas of the substrate and of the support. The drying of the layer of adhesive may then be carried out and the assembly thus completed.

Satisfactory operation of the device according to the invention is dependent on the absence of leaks in the region of the line 3 when a reduced pressure is applied to the space 4. In order to avoid any difficulty from this point of view, the device according to the invention may be equipped with means for measuring the flow rate of the gas sucked in when a reduced pressure is applied in the space 4, and means sensitive to the level of the gas flow rate to signal any occurrence of a leak in the region of the line of adhesive 3. Manual or automatic corrective measures are then implemented to suppress this leak. It will be observed in this connection that if the substrate 1 has a sufficient weight, the squashing of the line 3 under the influence of the weight of the substrate 1, when the latter is superposed on the support 2, is normally sufficient to prevent the occurrence of such leaks.

Because of the uniformity of the atmospheric pressure applied on the substrate 1 during the operation of the suction means, spreading of the adhesive is obtained in a continuous layer with a very uniform thickness which ensures the parallelism of the substrate and of the support. Because of this parallelism and the continuity of the layer on the opposing areas of the substrate and of the support, the transfers of heat required for cooling the components carried by the substrate take place out without hot points capable of damaging the circuit carried by the substrate. The uniformity of this heat transfer is, in addition, improved by the fact that the suction enables any air bubbles in the layer of adhesive spread by the method according to the invention to be removed, these bubbles being sucked in by the ducts 6 and 6' during the operation of the suction means.

The method according to the invention thus allows a substrate and a support to be assembled using a layer of adhesive with a uniform thickness, for example of the order of a tenth of a millimetre. If it is desired to fix the thickness of this layer precisely, it is possible to combine, either with the support or with the substrate, stop means such as spacing blocks with predetermined thicknesses.

Good substrate/support parallelism, and continuity and uniformity of the layer of adhesive distributed between these, which are obtained by the method and the device according to the present invention, give rise to the following advantages:
1) the absence of hot points during transfers of heat between the substrate and the support, as seen above, this absence of hot points having been confirmed by thermographic photographs,
2) the suppression of the appearance of parasitic vibrations during ultrasonic welding operations on the circuit carried by the substrate,
3) the improved resistance of the substrate to coming unstuck in a difficult environment, such as in automobile electronics,
4) the retention of the integral nature of the circuit carried by the substrate as a result of the absence of concentrated forces on the latter when the substrate is pressed against the support.

In addition to the quality and the reliability of the assembly obtained by the method according to the present invention, it will be noted that it lends itself to an advanced automatization.

The invention is, of course, not limited to the embodiment described and shown which has been given merely by way of example. In particular, the invention is not limited to the fastening in a casing of a substrate carrying a thick-layered hybrid circuit. On the contrary, the invention extends to fastening onto a support of any electronic circuit, such as a thin-layered hybrid circuit or even a printed circuit.

## Claims

1. Method for fastening a plane electronic circuit substrate (1) onto a plane support (2) parallel to the latter by depositing an adhesive product in the viscous state on one of the faces of the substrate or of the support to be fastened one on the other, characterized in that
(a) a looped line (3) of the adhesive product is deposited on one of said faces,
(b) these faces are placed opposite each other in order to establish a space (4) defined by the line of adhesive and the areas of the opposing faces which are inside the line,
(c) a reduced pressure is applied to this space (4) so as to squash the line of adhesive (3) between the two faces to be assembled, in order to spread the viscous adhesive in a layer with a substiantially constant thickness and
(d) the layer formed in this way is dried.

2. Method according to Claim 1, characterized in that the flow rate of the sucked in gas is measured in order to control the leaktightness of the line of adhesive and the positioning of the opposing faces is corrected in order to cancel this flow rate if necessary so as to ensure the application of a reduced pressure to the space (4) relative to the environment.

3. Method according to any one of the preceding claims, for an restangular substrate, characterized in that the line of adhesive is deposited in a cushion-shaped contour having the same axes of symmetry as the substrate.

4. Device for the implementation of the method according to Claim 1, comprising means for receiving a unit consisting of a plane support (2) and a substrate (1) separated by a looped line (3) of a viscous adhesive product, the plane support or the substrate being pierced with at least one opening (5, 5') which passes through its thickness to open out in the space (4) defined by the line of adhesive (3) and the opposing areas of the support and of the substrate which are inside the line of adhesive, this device being characterized in that it comprises suction means (6, 6'; 7, 7') connected to this opening for applying a reduced pressure to the said space (4) relative to the environment so as to cause the viscous adhesive product to spread in a uniform layer by squashing the line of adhesive (3) between the substrate and the support.

5. Device according to Claim 4, characterized in that it comprises means sensitive to the flow rate of the sucked in gas for signalling the occurrence of a leak in the region of the line of adhesive.

6. Device according to either of Claim 4 or 5, characterized in that stop means are interposed between the substrate and the support for setting the final thickness of the spread layer of adhesive.

7. Device according to any one of Claims 4 or 6, characterized in that it comprises means for coating one of the faces to be assembled with a looped line (3) of adhesive product, means for superposing in location the substrate and the support on either side of the line, and means (7, 7') for connecting the unit formed in this way to the suction means.

8. Device according to any one of Claims 4 to 7, characterized in that the connection means (7, 7') also form means for receiving the support (2) in the assembly position.

## Patentansprüche

1. Verfahren zum Fixieren eines ebenen Elektronikschaltungs-Substrates (1) auf einem ebenen Träger (2) parallel zu dem letzteren, durch Aufbringen eines Kleberprodukts in viskosem Zustand auf einer der aneinander zu fixierenden Flächen des Substrats oder des Trägers, dadurch gekennzeichnet, daß
(a) eine schleifenförmige Linie (3) des Kleberprodukts auf einer der Flächen aufgebracht wird;
(b) diese Flächen einander gegenüberliegend angeordnet werden, um einen Raum (4) zu bilden, der von der Kleberlinie und den innerhalb der Linie liegenden Bereichen der einander gegenüberliegenden Flächen definiert wird;
(c) ein Unterdruck an diesen Raum (4) angelegt wird, um die Kleberlinie (3) zwischen den zusammenzufügenden Flächen zusammenzupressen und dadurch den viskosen Kleber in einer Schicht im wesentlichen konstanter Dicke zu verteilen, und
(d) die auf diese Weise gebildete Schicht getrocknet wird.

2. Verfahren nach Anspruch 1, dadurch gekennzeichnet, daß der Strom des eingesaugten Gases gemessen wird, um die Dichtigkeit der Kleberlinie auf Leckstellen zu kontrollieren, und daß die Positionierung der gegenüberliegenden Flächen gegebenenfalls korrigiert wird, um diesen Strom aufzuheben und somit die Beaufschlagung des Raums (4) mit Unterdruck relativ zur Umgebung sicherzustellen.

3. Verfahren nach einem der vorhergehenden Ansprüche für ein rechteckiges Substrat, dadurch gekennzeichnet, daß die Kleberlinie in einer kissenförmigen Kontur aufgebracht wird, die die gleichen Symmetrieachsen wie das Substrat hat.

4. Vorrichtung zum Durchführen des Verfahrens nach Anspruch 1, mit einer Einrichtung zur Aufnahme einer Einheit aus einem ebenen Träger (2) und einem Substrat (1), die durch eine schleifenförmige Linie (3) eines viskosen Kleberproduktes getrennt sind, wobei der ebene Träger oder das Substrat von mindestens einer Öffnung (5,5') durchdrungen ist, die sich durch dessen Dicke erstreckt und in dem Raum (4) mündet, der von der Kleberlinie (3) und den innerhalb der Kleberlinie befindlichen gegenüberliegenden Bereichen des Trägers und des Substrats definiert ist, dadurch gekennzeichnet, daß die Vorrichtung Saugmittel (6,6'; 7,7') aufweist, die an dieser Öffnung angeschlossen sind, um an diesen Raum einen Unterdruck relativ zur Umgebung anzulegen, damit sich das viskose Kleberprodukt in einer gleichförmigen Schicht verteilt, indem die Kleberlinie (3) zwischen dem Substrat und dem Träger zusammengepreßt wird.

5. Vorrichtung nach Anspruch 4, dadurch gekennzeichnet, daß sie Mittel aufweist, die auf den Strom des eingesaugten Gases ansprechen, um das Auftreten eines Lecks in dem Bereich der Kleberlinie zu signalisieren.

6. Vorrichtung nach Anspruch 4 oder 5, dadurch gekennzeichnet, daß Anschlagmittel zwischen dem Substrat und dem Träger angeordnet sind, um die Enddicke der verteilten Kleberschicht festzulegen.

7. Vorrichtung nach Anspruch 4 oder 6, gekennzeichnet durch eine Einrichtung zum Beschichten einer der zusammenzufügenden Flächen mit einer schleifenförmigen Linie (3) eines Kleberprodukts, eine Einrichtung zum Übereinanderlegen des Substrats und des Trägers zu beiden Seiten der Linie und eine Einrichtung (7,7') zum Anschließen der auf diese Weise gebildeten Einheit an den Saugmitteln.

8. Vorrichtung nach einem der Ansprüche 4 bis 7, dadurch gekennzeichnet, daß die Anschlußeinrichtung (7,7') zugleich eine Einrichtung zur Aufnahme des Trägers (2) in der Zusammenbauposition bildet.

## Revendications

1. Procédé pour fixer un substrat de circuit électronique plan (1) sur un support plan (2) parallèle au substrat, par le dépôt d'un produit adhésif à l'état visqueux sur l'une des faces du substrat ou du support devant être fixées l'une sur l'autre, caractérisé en ce que :
(a) on dépose sur l'une des faces précitées une ligne fermée (3) du produit adhésif,
(b) on place ces faces en regard pour établir un espace (4) qui est défini par la ligne d'adhésif et par les régions des faces en regard qui se trouvent à l'intérieur de la ligne,
(c) on applique une pression réduite à cet espace (4) de façon à écraser la ligne d'adhésif (3) entre les deux faces à assembler, pour étaler l'adhésif visqueux en une couche ayant une épaisseur pratiquement constante, et
(d) on fait sécher la couche qui est formée de cette manière.

2. Procédé selon la revendication 1, caractérisé en ce que le débit du gaz qui est aspiré est mesuré dans le but de contrôler l'herméticité de la ligne d'adhésif, et le positionnement des faces en regard est corrigé dans le but de réduire ce débit à zéro, si nécessaire, de façon à garantir l'application d'une pression réduite à l'espace précité (4), par rapport à l'environnement.

3. Procédé selon l'une quelconque des revendications précédentes, pour un substrat rectangulaire, caractérisé en ce que l'on dépose la ligne d'adhésif avec un contour en forme de coussin ayant les mêmes axes de symétrie que le substrat.

4. Dispositif pour la mise en oeuvre du procédé selon la revendication 1, comprenant des moyens destinés à recevoir un ensemble comprenant un support plan (2) et un substrat (1) séparés par une ligne fermée (3) d'un produit adhésif visqueux, le support plan ou le substrat étant percé par au moins une ouverture (5, 5') qui traverse son épaisseur de façon à déboucher dans l'espace (4) qui est défini par la ligne d'adhésif (3) et les régions en regard du support et du substrat qui se trouvent à l'intérieur de la ligne d'adhésif, ce dispositif étant caractérisé en ce qu'il comprend des moyens d'aspiration (6, 6'; 7, 7') reliés à l'ouverture précitée, pour appliquer une pression réduite à l'espace précité (4), par rapport à l'environnement, de façon que le produit adhésif visqueux s étale en une couche uniforme sous l'effet de l'écrasement de la ligne d'adhésif (3) entre le substrat et le support.

5. Dispositif selon la revendication 4, caractérisé en ce qu'il comprend des moyens sensibles au débit du gaz qui est aspiré, de façon à signaler l'existence d'une fuite dans la région de la ligne d'adhésif.

6. Dispositif selon la revendication 4 ou 5, caractérisé en ce que des moyens de butée sont interposés entre le substrat et le support pour fixer l'épaisseur finale de la couche d'adhésif qui est étalée.

7. Dispositif selon l'une quelconque des revendications 4 ou 6, caractérisé en ce qu'il comprend des moyens pour déposer sur l'une des faces à assembler une ligne fermée (3) de produit adhésif, des moyens pour superposer le substrat et le support de part et d'autre de la ligne, et des moyens (7, 7') pour raccorder aux moyens d'aspiration l'ensemble ainsi formé.

8. Dispositif selon l'une quelconque des revendications 4 à 7, caractérisé en ce que les moyens de raccordement (7, 7') forment également des moyens qui sont destinés à recevoir le support (2) dans la position d'assemblage.
